# EUROPEAN PATENT APPLICATION

(11) **EP 3 346 809 A1**
(43) Date of publication of application: **11.07.2018**
(21) Application number: 17759438.9
(22) Date of filing: 18.01.2017
(51) Int. Cl.: H05K 3/46, H01L 23/12, H01L 25/00, H05K 1/11

(54) **ELECTRONIC CIRCUIT MODULE AND METHOD FOR TESTING ELECTRONIC CIRCUIT MODULE**

(30) Priority: 04.03.2016 JP 2016042057; 15.07.2016 JP 2016140007
(71) Applicant: Alps Electric Co., Ltd., Tokyo 145-8501 (JP)
(72) Inventor: MARUYAMA, Takashi, Tokyo 145-8501 (JP); SUDA, Shigeru, Tokyo 145-8501 (JP); MIYAZAKI, Masami, Tokyo 145-8501 (JP); INOKUCHI, Daisuke, Tokyo 145-8501 (JP)
(74) Representative: Schmitt-Nilson Schraud Waibel Wohlfrom Patentanwälte Partnerschaft mbB
(86) International application number: PCT/JP2017/001475
(87) International publication number: WO 2017/149966

(57) **Abstract**

[Object]

An electric circuit module, in which test-use electrodes are included in an inner layer of a multi-layer substrate and whose size is enabled to be smaller, is provided, and a test method of the electric circuit module, in which preliminary work for performing error analysis becomes easy, is provided.

[Solving Means]

An electric circuit module 100 is provided. The electric circuit module 100 includes a multi-layer substrate 10, and a plurality of electric parts 31 mounted on a top layer 10a of the multi-layer substrate 10. A plurality of land electrodes 11 that are necessary for normal operations are provided in a bottom layer of the multi-layer substrate 10. Test-use electrodes 13 connected to the electric parts 31 are provided in an inner layer 10c of the multi-layer substrate 10. The test-use electrodes 13 are not connected to the land electrodes 11. The test-use electrodes 13 are provided at a position at which the test-use electrodes 13 overlap the land electrodes 11 in a plan view.

## Description

### BACKGROUND OF THE INVENTION

### 1. Field of the Invention

The present invention relates to an electric circuit module, and, in particular, relates to an electric circuit module that includes a test-use electrode, and relates to a test method of the electric circuit module.

### 2. Description of the Related Art

In recent years, electric circuit modules that include a test-use electrode have been developed. The test-use electrode is included for identifying an electric part that causes an error at the time of error analysis. For example, in the case where electric parts are covered with sealing resin, test probes cannot be directly in contact with the electric parts. A plurality of test-use electrodes, which are connected to the electric parts through via-holes, are included in the bottom layer of a multi-layer substrate on which the electric parts are mounted. Conductivity checks, etc., are performed by causing the test probes to be in contact with the test-use electrodes.

However, as a result of the plurality of the test-use electrodes that must be included in the bottom layer of the multi-layer substrate in addition to a plurality of land electrodes that are necessary for operating the electric circuit module, an area of the multi-layer substrate is inevitably increased, which has caused the size of the electric circuit module to increase. Therefore, an electric circuit module that is not required to include a test-use electrode in the bottom layer of the multi-layer substrate has been developed. As this kind of the electric circuit module, a multi-layer printed wiring board 900 is disclosed in Patent Document 1. In the following, referring to Fig. 12, the multi-layer printed wiring board 900 will be described.

In the multi-layer printed wiring board 900, in order to execute a continuity check between circuits of layers before placing electronic components or an input/output functional test between the circuits of the layers after placing the electric components, copper foils 904 of predetermined portions of one surface or both surfaces of a substrate 301 are removed by etching, an insulating layer 902 exposed at the portions is removed by dissolving it in alkaline water solution to expose lands 906, 908, and 909 of an inner layer circuit. Further, check lands 916, 917, and 918 for checking electrical connections between the circuits of the layers or for testing functions are formed at the lands 906, 908, and 909, respectively.

According to the arrangements described above, the check lands for checking electrical connection between the circuits of the layers or for testing functions can be formed by using the lands of the inner layer circuit.

### [Citation List]

### [Patent Document]

[Patent Document 1] Japanese Unexamined Patent Application Publication No. H07-007272

### SUMMARY OF THE INVENTION

### [TECHNICAL PROBLEM]

However, in the multi-layer printed wiring board 900, an area that is used for exposing the check lands 916, 917, and 918 is required in a top layer and a bottom layer of a substrate 901. Further, when some parts of the electric circuits including a wiring pattern, etc., are provided in the top layer and the bottom layer, it is necessary to avoid the area in which those parts are provided to expose the check lands 916, 917, and 918. Therefore, it becomes necessary to make an area of the substrate 901 larger than the conventional area. As a result, there is a problem that it is difficult to make the size of the electric circuit module smaller.

### [SOLUTION TO PROBLEM]

In view of the above-described problem of conventional technologies, the present invention provides an electric circuit module that includes a test-use electrode in an inner layer of a multi-layer substrate and whose size is easy to be made smaller, and provides a test method of the electric circuit module in which preliminary work for performing error analysis becomes easy.

In order to solve the above-described problem, an electric circuit module according to an embodiment of the present invention includes a multi-layer substrate, and a plurality of electric parts mounted on a top layer of the multi-layer substrate, and has the features that a plurality of land electrodes that are necessary for normal operations are provided in a bottom layer of the multi-layer substrate, that test-use electrodes connected to the electric parts are provided in an inner layer of the multi-layer substrate, that the test-use electrodes are not connected to the land electrodes, and that the test-use electrodes are provided at a position at which the test-use electrodes overlap the land electrodes in a plan view.

The above-described electric circuit module includes the test-use electrodes used for an error analysis at a position, in an inner layer of the multi-layer substrate, at which the test-use electrodes overlap the land electrodes in a plan view. Therefore, it is not necessary for the electric circuit module to have an area that is used for exposing the test-use electrodes in the bottom layer of the multi-layer substrate. As a result, it is not necessary to increase an area of the bottom layer of the multi-layer substrate, and thus, it becomes possible to reduce the size of the electric circuit module.

Furthermore, in the above-described arrangement, the electric circuit module has the features that the test-use electrodes are formed by non-penetrating via-holes made of conductive material.

In the above-described electric circuit module, because the test-use electrodes are formed by non-penetrating via holes, the test-use electrodes have a thickness in the thickness direction of the multi-layer substrate, and have a thickness in the lateral direction of the multi-layer substrate. As a result, even when the accuracy of the grinding amount of an insulating layer of the multi-layer substrate is low, the test-use electrodes can be still exposed easily.

Further, the above-described electric circuit module has the features that at least one of the test-use electrodes is a first test-use electrode whose lower end surface is provided at one layer above the bottom layer of the multi-layer substrate, and that no wiring pattern is provided in the bottom layer of the multi-layer substrate.

In the above-described electric circuit module, because of the fact that the lower end surface of the first test-use electrode is provided at one layer above the bottom layer of the multi-layer substrate, when exposing the test-use electrode used for an error analysis, it is only necessary to grind the insulating layer of the bottom layer of the multi-layer substrate. Further, because of the fact that no wiring pattern is provided in the bottom layer of the multi-layer substrate, no wiring pattern will be cut.

Further, in the above-described case, at least one of the test-use electrodes is a second test-use electrode that is provided in the vicinity of the side end portion of the multi-layer substrate, and no wiring pattern is provided at least at a position, of the side end portion of the multi-layer substrate, in the vicinity of the second test-use electrode.

In the above-described electric circuit module, because of the fact that the second test-use electrode is provided in the vicinity of the side end portion of the multi-layer substrate, when exposing the test-use electrode used for an error analysis, it is only necessary to grind the side end portion of the multi-layer substrate. Further, because of the fact that no wiring pattern is provided at least at a position, of the side end portion of the multi-layer substrate, in the vicinity of the second test-use electrode, no wiring pattern will be cut.

Further, in the above-described case, the non-penetrating via holes are stacked via holes that are formed in a straight line in a direction perpendicular to the top layer of the multi-layer substrate.

In the above-described electric circuit module, it is possible to cause the non-penetrating via holes that form the test-use electrode to have a minimum required length, and thus, the impact on the performance of the electric circuit module can be reduced.

Further, the above-described electric circuit module has the features that part pads for the electric parts are provided in the top layer of the multi-layer substrate, and that connection lands of the non-penetrating via holes on the top layer are used in common with the part pads.

In the above-described electric circuit module, it is possible to improve the wiring space efficiency by a pad-on-via in which the connection lands of the non-penetrating via holes in the top layer are used in common with the part pads.

Further, the above-described electric circuit module has the features that the electric parts are sealed with resin.

In the above-described electric circuit module, even though the electric parts are sealed with resin, it is not necessary to grind the sealing resin in order to expose the test-use electrode.

In order to solve the above-described problem, a first test method of an electric circuit module according to an embodiment of the present invention is a test method of an electric circuit module that includes a multi-layer substrate and a plurality of electric parts mounted on a top layer of the multi-layer substrate, wherein a plurality of land electrodes necessary for ordinary operations are provided in a bottom layer of the multi-layer substrate, and test-use electrodes connected to the electric parts are provided in an inner layer of the multi-layer substrate. The method includes providing the test-use electrodes at a position at which the test-use electrodes overlaps the land electrodes in a plan view, causing at least one of the test-use electrode to be a first test-use electrode whose lower end surface is provided at one layer above the bottom layer of the multi-layer substrate, not connecting the first test-use electrode to the land electrode, not providing a wiring pattern in the bottom layer of the multi-layer substrate, and exposing the first test-use electrode by grinding the bottom layer of the multi-layer substrate at the time of analysis.

In the above-described first test method of the electric circuit module, because of the fact that the lower end surface of the first test-use electrode is provided at one layer above the bottom layer of the multi-layer substrate, when exposing the test-use electrode used for an error analysis, it is only necessary to grind the insulating layer of the bottom layer of the multi-layer substrate. Further, because of the fact that no wiring pattern is provided in the bottom layer of the multi-layer substrate, no wiring pattern will be cut. Therefore, preliminary work for performing error analysis becomes easier.

In order to solve the above-described problem, a second test method of an electric circuit module according to an embodiment of the present invention is a test method of an electric circuit module that includes a multi-layer substrate and a plurality of electric parts mounted on a top layer of the multi-layer substrate, wherein a plurality of land electrodes necessary for ordinary operations are provided in a bottom layer of the multi-layer substrate, and test-use electrodes connected to the electric parts are provided in an inner layer of the multi-layer substrate. The method includes providing the test-use electrodes at a position at which the test-use electrodes overlaps the land electrodes in a plan view, causing at least one of the test-use electrode to be a second test-use electrode provided in the vicinity of the side end portion of the multi-layer substrate, not connecting the second test-use electrode to the land electrode, not providing a wiring pattern at least at a position, of the side end portion of the multi-layer substrate, in the vicinity of the second test-use electrode, and exposing the second test-use electrode by grinding the side end portion of the multi-layer substrate at the time of analysis.

In the above-described second test method of the electric circuit module, because of the fact that the second test-use electrode is provided in the vicinity of the side end portion of the multi-layer substrate, when exposing the test-use electrode used for an error analysis, it is only necessary to grind the side end portion of the multi-layer substrate. Further, because of the fact that no wiring pattern is provided at least at a position, of the side end portion of the multi-layer substrate, in the vicinity of the second test-use electrode, no wiring pattern will be cut. Therefore, preliminary work for performing error analysis becomes easier.

### [ADVANTAGEOUS EFFECTS OF INVENTION]

An electric circuit module according to an embodiment of the present invention includes the test-use electrodes used for an error analysis at a position, in an inner layer of the multi-layer substrate, at which the test-use electrodes overlap the land electrodes in a plan view. Therefore, it is not necessary for the electric circuit module to have an area that is used for exposing the test-use electrodes in the bottom layer of the multi-layer substrate. As a result, it is not necessary to increase an area of the bottom layer of the multi-layer substrate, and thus, it becomes possible to reduce the size of the electric circuit module. Further, in the above-described first test method of the electric circuit module, because of the fact that the lower end surface of the first test-use electrode is provided at one layer above the bottom layer of the multi-layer substrate, when exposing the test-use electrode used for an error analysis, it is only necessary to grind the insulating layer of the bottom layer of the multi-layer substrate. Further, because of the fact that no wiring pattern is provided in the bottom layer of the multi-layer substrate, no wiring pattern will be cut. Therefore, preliminary work for performing error analysis becomes easier. Further, in the above-described second test method of the electric circuit module, because of the fact that the second test-use electrode is provided in the vicinity of the side end portion of the multi-layer substrate, when exposing the test-use electrode used for an error analysis, it is only necessary to grind the side end portion of the multi-layer substrate. Further, because of the fact that no wiring pattern is provided at least at a position, of the side end portion of the multi-layer substrate, in the vicinity of the second test-use electrode, no wiring pattern will be cut. Therefore, preliminary work for performing error analysis becomes easier.

### BRIEF DESCRIPTION OF THE DRAWINGS

Fig. 1 is a perspective view illustrating an appearance of an electric circuit module according to an embodiment of the present invention.
Fig. 2 is a plan view of the electric circuit module viewed from the top.
Fig. 3 is a plan view of the electric circuit module viewed from the bottom.
Fig. 4 is a sectional view of the electric circuit module.
Fig. 5 is a partially enlarged schematic drawing of the electric circuit module.
Fig. 6 is a sectional view illustrating a first test method of the electric circuit module.
Fig. 7 is a sectional view illustrating a second test method of the electric circuit module.
Fig. 8 is a sectional view illustrating a first modified example of the second test method.
Fig. 9 is a partially enlarged schematic drawing illustrating a first modified example of the second test method.
Fig. 10 is a partially enlarged schematic drawing illustrating a second modified example of the second test method.
Fig. 11 is a partially enlarged schematic drawing illustrating a third modified example of the second test method.

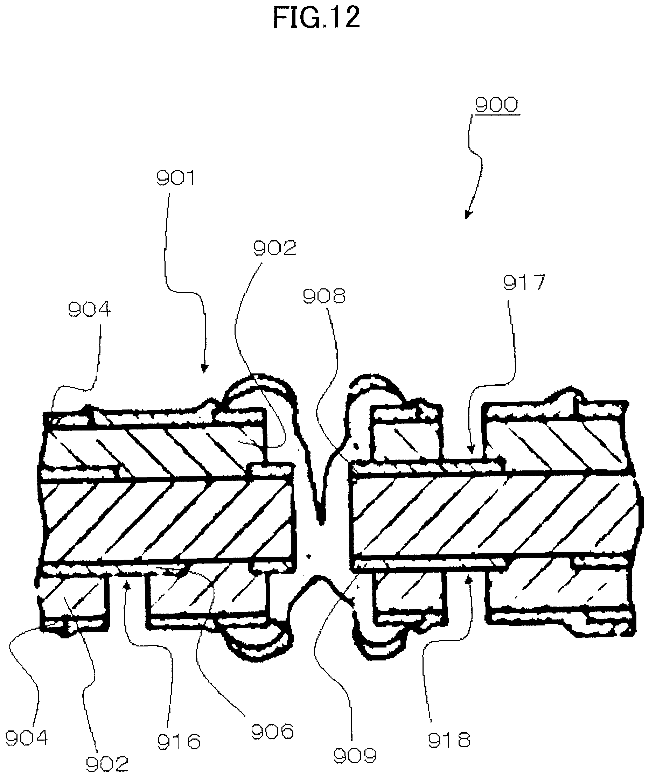

Fig. 12 is a sectional view of a multi-layer printed wiring board according to a conventional example.

### DETAILED DESCRIPTION OF THE PREFERRED EMBODIMENTS

In the following, referring to the drawings, an electric circuit module and a test method of the electric circuit module according to an embodiment of the present invention will be described. An electric circuit module according to an embodiment of the present invention is, for example, a small electric circuit module that includes a high-frequency circuit used for a wireless LAN (Local Area Network), Bluetooth (registered trademark), etc., and that is mounted on an electric device such as a smart-phone. The use of the electric circuit module according to an embodiment of the present invention is not limited to an embodiment described below, and various modifications may be made. It should be noted that, in the case where "right side", "left side", "upper side", and "lower side" are used in the descriptions for the drawings, they indicate "+X side", "-X side", "+Z side", and "-Z side", respectively, in each of the drawings.

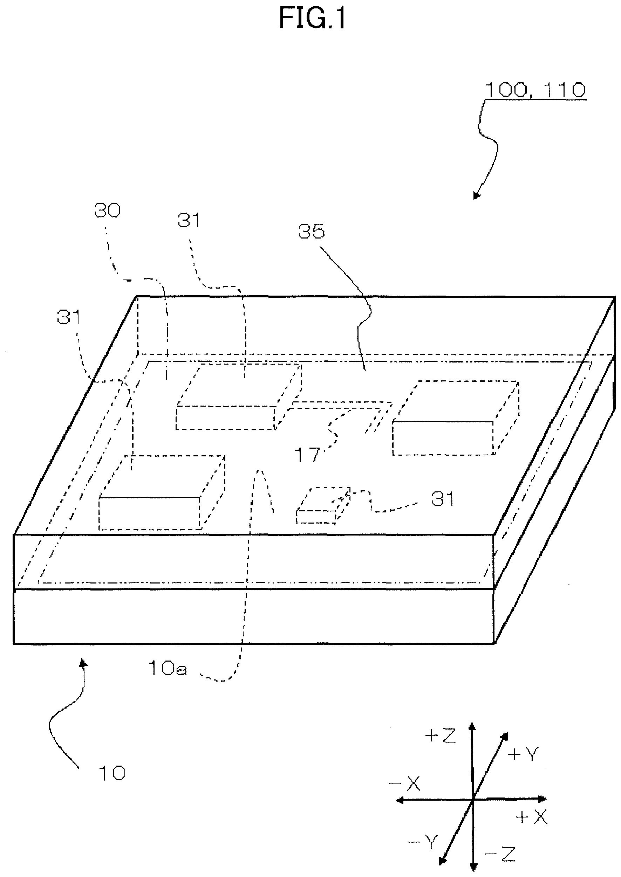

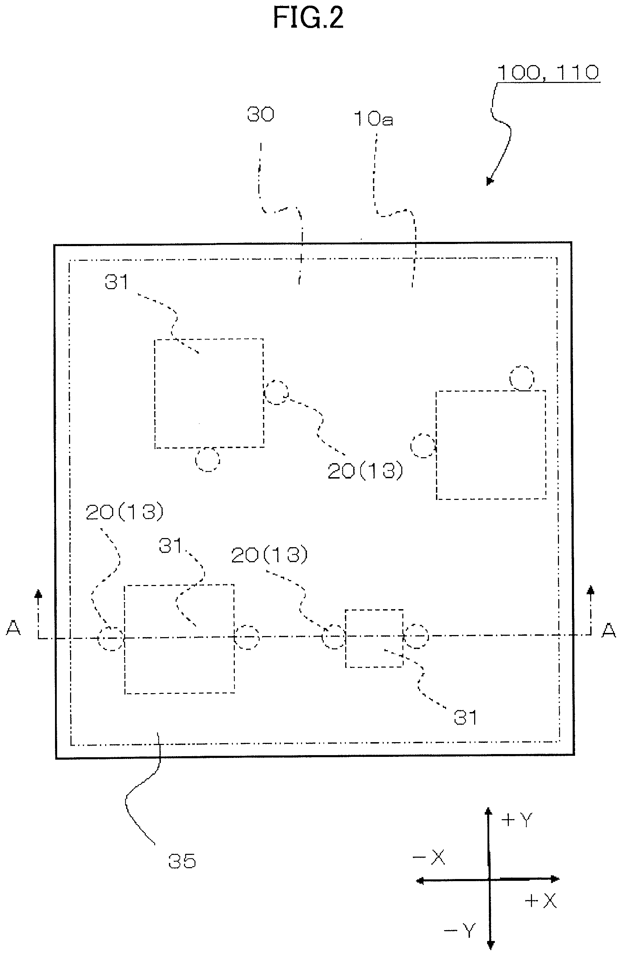

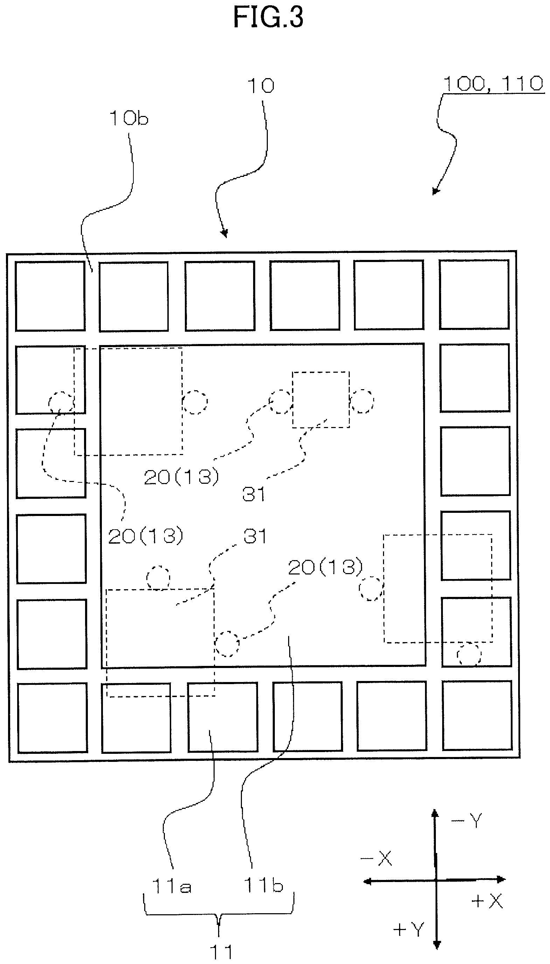

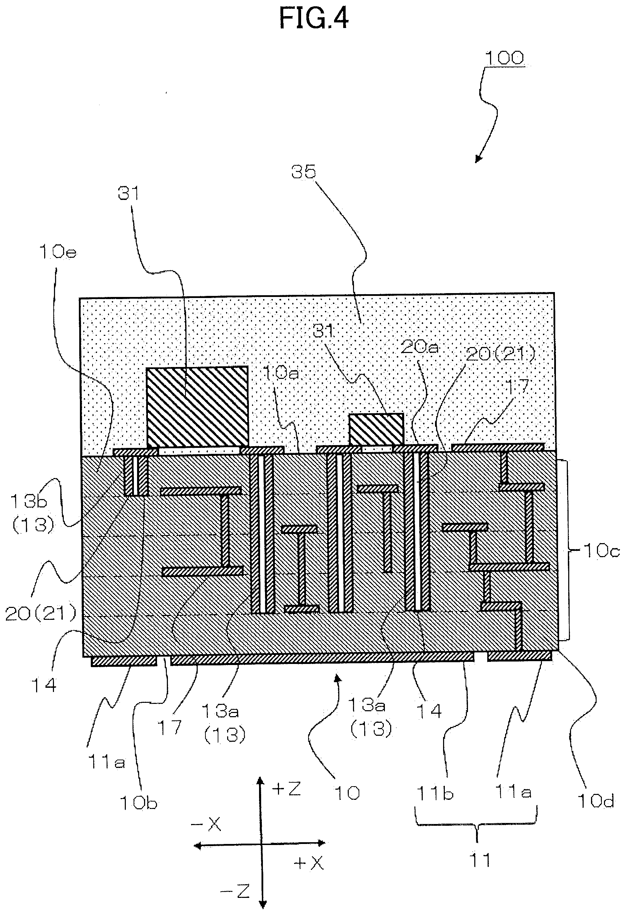

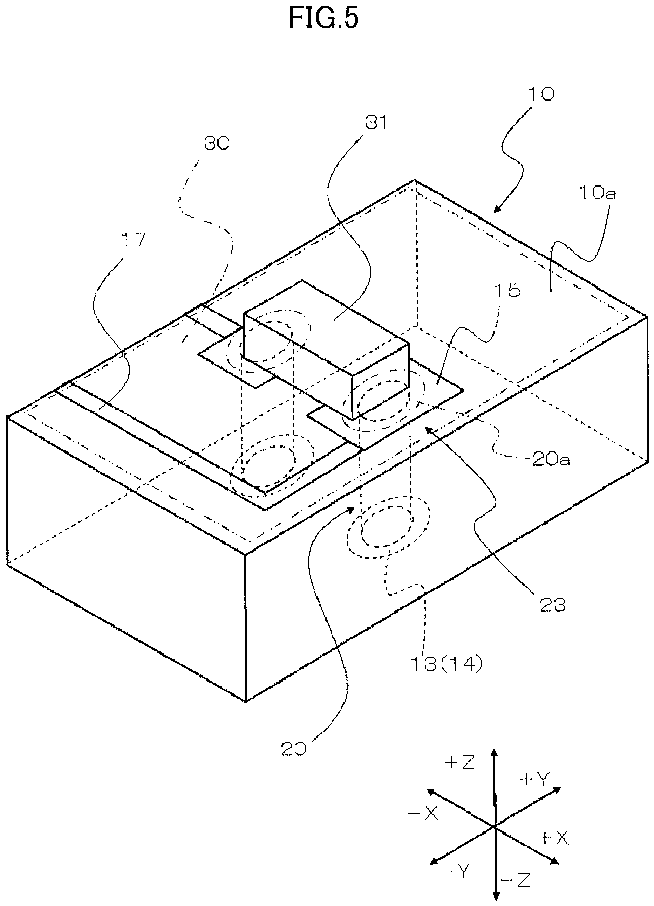

First, referring to Fig. 1 through Fig. 5, a structure of an electric circuit module 100 according to an embodiment of the present invention will be described. Fig. 1 is a perspective view illustrating an appearance of the electric circuit module 100. Fig. 2 is a plan view of the electric circuit module 100 viewed from the top. Fig. 3 is a plan view of the electric circuit module 100 viewed from the bottom. Further, Fig. 4 is a sectional view of the electric circuit module 100 viewed from an A-A line illustrated in Fig. 2. Fig. 5 is a partially enlarged schematic drawing of the electric circuit module 100. It should be noted that Fig. 5 illustrates a state before an electric part 31 is sealed with resin.

As illustrated in Fig. 1 and Fig. 2, the electric circuit module 100 includes a rectangular multi-layer substrate 10 and a plurality of electric parts 31 that are mounted on the top layer 10a of the multi-layer substrate 10. As illustrated in Fig. 4, the multi-layer substrate 10 is a multi-layer substrate with six layers including the top layer 10a, the bottom layer 10b, and four inner layers 10c. A wiring pattern 17 is formed in the top layer 10a and the inner layers 10c of the multi-layer substrate 10. An electric circuit 30 is formed by the wiring pattern 17 and a plurality of electric parts 31.

The plurality of the electric parts 31 are sealed with sealing resin 35 that covers substantially all areas of the multi-layer substrate. The sealing resin 35 is made of thermosetting molding material in which the principal component is an epoxy resin and a silica filler, or the like, is added. The sealing resin 35 is used for protecting the electric parts 31 on the multi-layer substrate 10 from heat and moisture environments.

As illustrated in Fig. 3, a plurality of land electrodes 11 necessary for the normal operations are provided in the bottom layer 10b of the multi-layer substrate 10. The land electrodes 11 include a plurality of first land electrodes 11a and a single second land electrode 11b. The plurality of the first land electrodes 11a are used as, for example, a power supply terminal for supplying power to the electric circuit 30, an input terminal, an output terminal, and the like, of the electric circuit 30. In the electric circuit module 100, the first land electrodes 11 are provided along the circumference of a surface of the bottom layer 10b of the multi-layer substrate 10.

The second land electrode 11b is formed in the center of the bottom layer 10b of the multi-layer substrate 10. The second land electrode 11b has an area greater than the first land electrode 11a. The second land electrode 11b is used as a ground terminal of the electric circuit 30. It should be noted that the second land electrode 11b is formed by a single large land pattern. However, the second land electrode 11b may be formed by arranging a plurality of small land patterns.

The plurality of the land electrodes 11, which are provided in the bottom layer 10b of the multi-layer substrate 10, are attached to an electric device such as a smart-phone in which the electric circuit module 100 is included, and thus, the electric circuit 30 is electrically connected to a circuit inside the electric device.

The electric circuit module 100 includes test-use electrodes 13 that are used for identifying an electric part 31 that is a cause of an error when analyzing the error. In case of the electric circuit module 100, because of the fact that the electric parts 31 are covered with the sealing resin 35, a test probe cannot be directly in contact with a terminal included in the electric parts 31. Therefore, it is necessary that the test-use electrodes 13 be provided in the multi-layer substrate on which the electric parts 31 are mounted. As illustrated in Fig. 4, in the electric circuit module 100, the test-use electrodes 13 are provided in the inner layers 10c of the multi-layer substrate 10. It should be noted that there are multiple test-use electrodes 13 included in the electric circuit module 100. Further, as it is not necessary to provide a test-use electrode that is used for checking the land electrodes 11 themselves for analyzing an error, the test-use electrodes 13 and the land electrodes 11 are not connected.

The test-use electrodes 13 are connected to the electric parts 31 that are error analysis targets, or to a point in the middle of the wiring pattern 17 that connects a plurality of the electric parts 31. As illustrated in Fig. 4, a test-use electrode 13 is formed by a non-penetrating via hole 20 that is made of conductive material. Further, a connection land 20a of the non-penetrating via hole 20, which is formed in the top layer 10a of the multi-layer substrate 10, is connected to an electric part 31.

The non-penetrating via hole 20 is not a via hole in which the layers in the multi-layer substrate are connected from the top layer 10a to the bottom layer 10b, but is a via hole which is formed from the top layer 10a or the bottom layer 10b to the inner layers 10c. In the electric circuit module 100, the non-penetrating via hole 20 is formed from the top layer 10a to the inner layers 10c.

At least one of the plurality of the test-use electrodes 13 is a first test-use electrode 13a. A lower end surface of the first test-use electrode 13a is provided at one layer above the bottom layer 10b of the multi-layer substrate 10. Therefore, the test-use electrode 13 does not exist in an insulating layer 10d between the bottom layer 10b and a layer one layer above. Further, no wiring pattern 17 is provided in the bottom layer 10b of the multi-layer substrate 10.

Further, at least one of the plurality of the test-use electrode 13 is a second test-use electrode 13b. The second test-use electrode 13b is provided in the vicinity of a side end portion 10e of the multi-layer substrate 10. Further, no wiring pattern 17 is provided at least at a position, of the side end portion 10e of the multi-layer substrate 10, in the vicinity of the second test-use electrode 13b. It should be noted that a lower end surface 14 of the second test-use electrode 13b in the electric circuit module 100 is provided at one layer below the top layer 10a of the multi-layer substrate 10. In other words, the length of the second test-use electrode 13b is a length of a single layer of the insulating layer 10d.

In the electric circuit module 100, the non-penetrating via hole 20, which forms the test-use electrodes 13, is a stacked via hole 21 that is formed in a straight line in a direction perpendicular to the top layer 10a of the multi-layer substrate 10 (in a downward direction). The stacked via hole 21 is a via hole in which all of the vias formed in the inner layers 10c of the multi-layer substrate 10 are at the same position in a plan view.

Therefore, the test-use electrodes 13 (the first test-use electrode 13a and the second test-use electrode 13b) are formed in substantially a cylinder shape by extending from a connection land 20a in the top layer 10a toward the right downward direction (-Z direction). Therefore, as illustrated in Fig. 2 or Fig. 3, when viewed from the top direction or the bottom direction in a plan view, the non-penetrating via holes 20 (i.e., the test-use electrodes 13) are formed in a circular shape.

It is possible to cause the length of the non-penetrating via holes 20, which form the test-use electrodes 13, to be a minimum required length, and thus, the impact on the performance of the electric circuit module can be reduced.

It should be noted that the stacked via holes 21 are used as the non-penetrating via holes 20 that form the test-use electrodes 13 in the electric circuit module 100. However, staggered vias, whose upper and lower vias are not at the same position in a plan view, may also be used as the non-penetrating via holes 20. Further, in the electric circuit module 100, when forming the stacked via holes 21 in the multi-layer substrate 10, the stacked via holes 21 are formed, not by forming the stacked via holes 21 after the layers of the multi-layer substrate 10 have been layered, but by layering the layers, in which the via hole has already been formed, in the vertical direction.

As illustrated in Fig. 5, a resin is filled in an opening in the top layer 10a of the non-penetrating via hole 20, metal plating is applied to the resin, and the connection land 20a, which does not have a hole in the center, is formed on the top layer 10a of the multi-layer substrate 10. Further, a part pad 15 for the electric part 31 is provided in the top layer 10a, and the electric part 31 is attached to the part pad 15 via soldering, or the like.

In the electric circuit module 100, the connection land 20a, which is provided in the top layer 10a of the non-penetrating via hole 20, is used in common with the part pad 15. In other words, a pad on via 23 of the non-penetrating via hole 20 is formed in the top layer 10a of the multi-layer substrate 10. It is possible to improve the wiring space efficiency in the top layer 10a by forming the pad on via 23 in the top layer 10a of the multi-layer substrate 10.

Further, as illustrated in Fig. 4, the wiring pattern 17, which is used for connecting the plurality of the electric parts 31 to each other or which is used for connecting the plurality of the electric parts 31 to the land electrodes 11, is provided in the top layer 10a and the inner layers 10c of the multi-layer substrate 10, but is not provided in the bottom layer 10b of the multi-layer substrate 10 as described above. Therefore, in the bottom layer 10b of the multi-layer substrate 10, nothing is formed other than the plurality of the land electrodes 11 (the first land electrodes 11a and the second land electrode 11b). Further, the test-use electrodes 13 are provided at positions at which the test-use electrodes 13 overlap the land electrodes 11 in a plan view.

For example, the test-use electrodes 13, which are provided on the left side and the right side of the electric part 31 that is arranged on the right side in Fig. 4, are provided at positions at which the test-use electrodes 13 overlap the second land electrode 11b in a plan view. Further, the test-use electrodes 13, which are provided on the left side and the right side of the electric part 31 that is arranged on the left side in Fig. 4, are provided at positions at which the test-use electrodes 13 overlap the first land electrode 11a or the second land electrode 11b in a plan view.

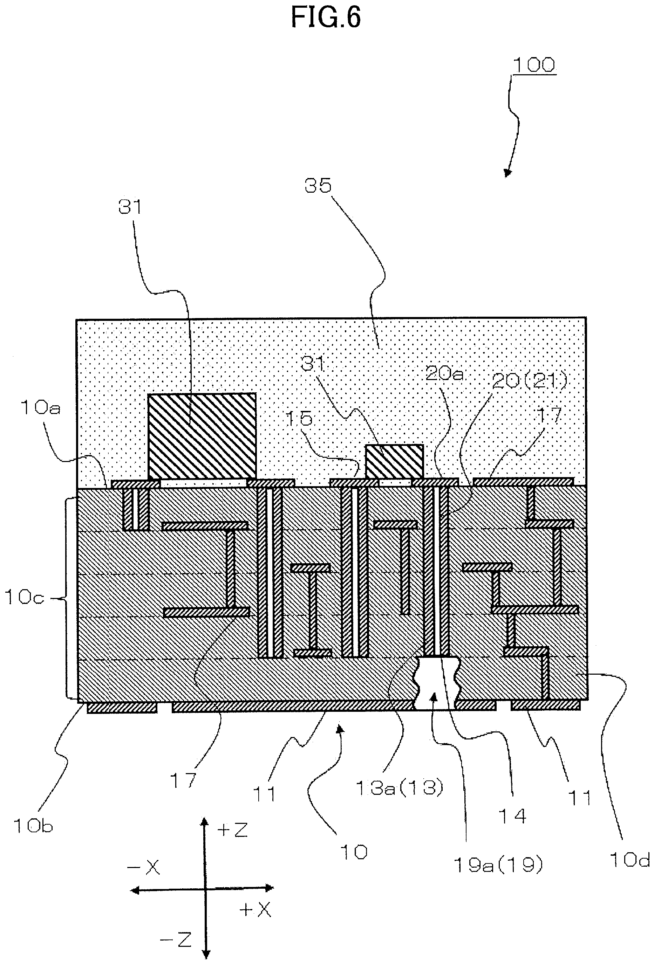

Next, referring to Fig. 6, a state of the electric circuit module 100 in a first test method of an electric circuit module according to an embodiment of the present invention, that is, a state of the electric circuit module 100 at the time of preliminary work for performing error analysis, will be described. Fig. 6 is a sectional view illustrating the first test method of the electric circuit module 100 viewed from A-A line in Fig. 2.

As illustrated in Fig. 6, at least one of the test-use electrodes 13 is a first test-use electrode 13a. In the first test method of the electric circuit module, in case of performing an error analysis of the electric circuit module 100, for example, in case of performing an error analysis of an electric part 31 on the right side in Fig. 6, a ground part 19 is formed right under the first test-use electrode 13a, which is connected to the electric part 31, in the multi-layer substrate 10. The ground part 19 right under the first test-use electrode 13a is a drilled hole 19a. The drilled hole 19a can be formed by drilling the land electrode 11 and the insulating layer 10d that are formed on the bottom layer 10b.

In other words, the first test method of the electric circuit module is a test method in which the first test-use electrode 13a is exposed by drilling the bottom layer 10b of the multi-layer substrate 10 at the time of analysis. It should be noted that a drill may be used for forming the drilled hole 19a, or, a laser beam may be applied to the bottom layer 10b of the multi-layer substrate 10 from the lower side (-Z side).

A lower end surface 14 of the first test-use electrode 13a is exposed by forming the drilled hole 19a in the multi-layer substrate 10. As described above, because of the fact that the lower end surface 14 of the first test-use electrode 13a is provided at one layer above the bottom layer 10b of the multi-layer substrate 10, in order to expose the lower end surface 14, it is only necessary to drill a layer amount of the insulating layer 10d above the bottom layer 10b, and thus, preliminary work for performing analysis becomes easier.

It should be noted that, in order to expose the lower end surface 14 of the test-use electrode 13, not only the bottom layer 10b and the insulating layer 10d right under the lower end surface 14 of the first test-use electrode 13a may be drilled, but also all of the bottom layer 10b of the multi-layer substrate 10 and all of a layer amount of the insulating layer 10d above the bottom layer 10b may be drilled.

Further, in the electric circuit module 100, the lower end surface 14 of the first test-use electrode 13a is provided at one layer above the bottom layer 10b of the multi-layer substrate 10. However, the lower end surface 14 may be provided at a layer (position) other than the above-described layer (position). Further, as described above, because of the fact that the first test-use electrode 13a is formed as the non-penetrating via hole 20 that has a thickness in the thickness direction of the multi-layer substrate 10, regardless of which layer the lower end surface 14 of the first test-use electrode 13a is provided in, and regardless of the drilling depth accuracy when drilling the insulating layer 10d of the multi-layer substrate 10, it is easy to expose the first test-use electrode 13a.

Further, because of the fact that no wiring pattern 17 is formed in the bottom layer 10b of the multi-layer substrate 10, no wiring pattern 17 will be cut when forming the ground part 19 (drilled hole 19a) in the multi-layer substrate 10. Therefore, at the time of an error analysis, no impact will be made on the result.

After forming the drilled hole 19a in the multi-layer substrate 10, it is possible to perform checking, of the electric part 31 on the right side, for an error analysis by causing a probe for checking to be in contact with the lower end surface 14 of the first test-use electrode 13a. The same descriptions can be applied to first electrodes 13a for testing that are formed for other electric parts 31. In this way, because of the fact that the probe for checking is caused to be in contact with the lower end surface 14 of the first test-use electrode 13a through the drilled hole 19a formed in the bottom layer 10b of the multi-layer substrate 10, even if the electric part 31 is sealed with the sealing resin 35, it is not necessary to grind the sealing resin 35 in order to expose the first test-use electrode 13a.

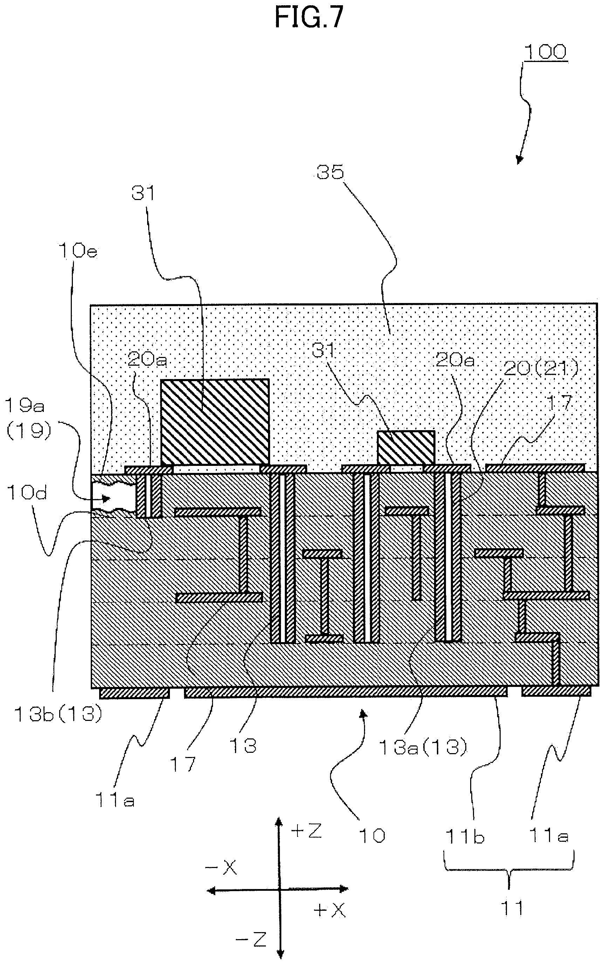

Next, referring to Fig. 7, a state of the electric circuit module 100 in a second test method of an electric circuit module according to an embodiment of the present invention, that is, a state of the electric circuit module 100 at the time of preliminary work for performing error analysis, will be described. Fig. 7 is a sectional view illustrating the second test method of the electric circuit module 100 viewed from A-A line in Fig. 2.

As illustrated in Fig. 7, at least one of the test-use electrodes 13 is a second test-use electrode 13b. For example, in case of performing an error analysis of an electric part 31 on the left side in Fig. 7, a ground part 19 (drilled hole 19a) is formed right beside (right on the left side of) the test-use electrode 13 (i.e., the second test-use electrode 13b), which is connected to the left side of the electric part 31, in the multi-layer substrate 10. In other words, the second test method of the electric circuit module is a test method in which the second test-use electrode 13b is exposed by drilling the side end portion 10e of the multi-layer substrate 10 at the time of analysis.

A side end portion surface of the second test-use electrode 13b is exposed by forming the drilled hole 19a in the multi-layer substrate 10. As described above, the second test-use electrode 13b is provided in the vicinity of the side end portion 10e of the multi-layer substrate 10. Therefore, it is only necessary to drill the insulating layer 10d of the side end portion 10e in the multi-layer substrate 10, and thus, preliminary work for performing analysis becomes easier.

Further, because of the fact that no wiring pattern 17 is provided at least at a position, of the side end portion 10e of the multi-layer substrate 10, in the vicinity of the second test-use electrode 13b, no wiring pattern will be cut when forming the drilled hole 19a in the multi-layer substrate 10. Therefore, at the time of an error analysis, no impact will be made on the result.

After forming the drilled hole 19a, which extends to the ground part 19 (drilled hole 19a), in the multi-layer substrate 10, it is possible to perform checking, of the electric part 31 on the left side in Fig. 7, for an error analysis by causing a probe for checking to be in contact with the left side surface of the second test-use electrode 13b.

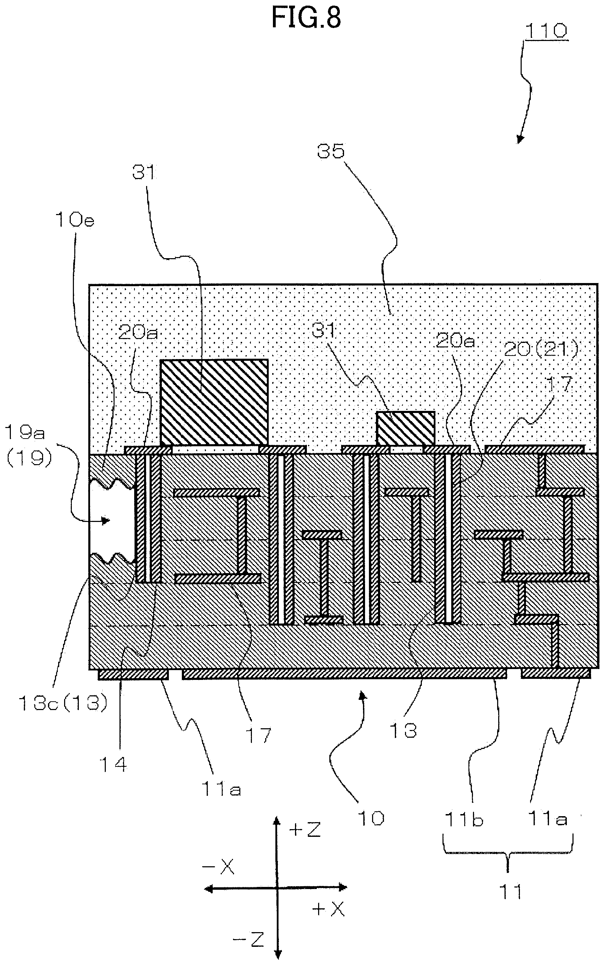

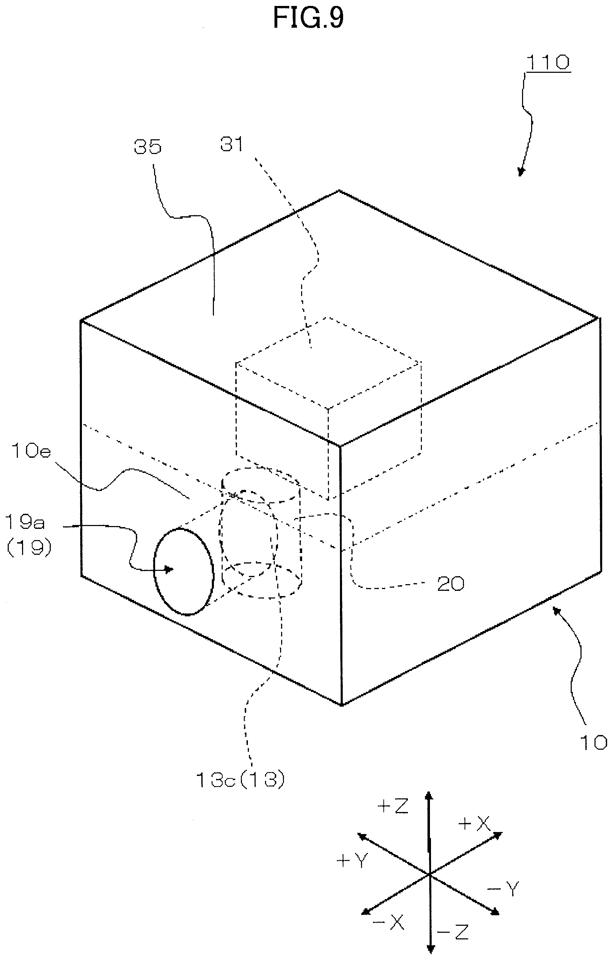

Next, referring to Fig. 8 and Fig. 9, a state of an electric circuit module 110 in the second test method of an electric circuit module 110 according to an embodiment of the present invention, that is, a state of the electric circuit module 110 at the time of preliminary work for performing error analysis, will be described. Fig. 8 is a sectional view of the electric circuit module 110 in the second test method (first modified example) viewed from A-A line in Fig. 2. Fig. 9 is a partially enlarged schematic drawing of the electric circuit module 110 in the second test method (first modified example). It should be noted that Fig. 1 through Fig. 3 are common for the electric circuit module 100 and for the electric circuit module 110.

The only difference between the electric circuit module 110 and the above-described electric circuit module 100 is that the length of the second test-use electrode 13c of the electric circuit module 110 is different from the length of the second test-use electrode 13b of the electric circuit module 100. The electric circuit module 110 is the same as the electric circuit module 100 other than the above difference. Therefore, the descriptions of the parts of the electric circuit module 110 that are the same as the electric circuit module 100 will be omitted.

As illustrated in Fig. 8 and Fig. 9, in the electric circuit module 110, the second test-use electrode 13c is formed for the electric part 31 on the left side in Fig. 8. The second test-use electrode 13c is provided in the vicinity of the side end portion 10e of the multi-layer substrate 10, and no wiring pattern 17 is provided at least at a position, of the side end portion 10e of the multi-layer substrate 10, in the vicinity of the second test-use electrode 13c. As illustrated in Fig. 8, a lower end surface 14 of the second test-use electrode 13c in the electric circuit module 110 is provided at three layers below the top layer 10a of the multi-layer substrate 10. In other words, the length of the second test-use electrode 13c is a length of three layers of the insulating layer 10d. It should be noted that the length of the second test-use electrode 13c is not limited to the three layers amount as long as it has a length of multiple layers.

In case of performing an error analysis of an electric part 31 of the electric circuit module 110 on the left side in Fig. 8, similar to the case of the electric circuit module 100, as illustrated in Fig. 8 and Fig. 9, a ground part 19 (drilled hole 19a) is formed right beside (right on the left side of) the test-use electrode 13 (i.e., the second test-use electrode 13c), which is connected to the left side of the electric part 31, in the side end portion 10e of the multi-layer substrate 10.

In case of the electric circuit module 100, the length of the second test-use electrode 13b is only an amount of one layer of the insulating layer 10d, and thus, it is very difficult to form the drilled hole 19a when the size of the electric circuit module 100 is small. In case of the electric circuit module 110, however, the length of the second test-use electrode 13c is a length of multiple layers of the insulating layer 10d (length of three layers in Fig. 8), and thus, it is easier to form the drilled hole 19a even when the size of the electric circuit module 110 is small.

The drilled hole 19a can be formed in the insulating layer 10d of the side end portion 10e in the multi-layer substrate 10 by using a drill, or the like. Further, in order to form the drilled hole 19a, laser light may be applied to the multi-layer substrate 10 from the left side (-X side).

It should be noted that the second test-use electrode 13c has a length of an amount of multiple layers of the insulating layers 10d, and, by appropriately setting the length of the second test-use electrode 13c, it is possible to form a stub circuit such as an open stub and a short stub. As a result, by using the stub circuit, it becomes possible to form a filter circuit such as an impedance matching circuit and a trap circuit in the electric circuit 30.

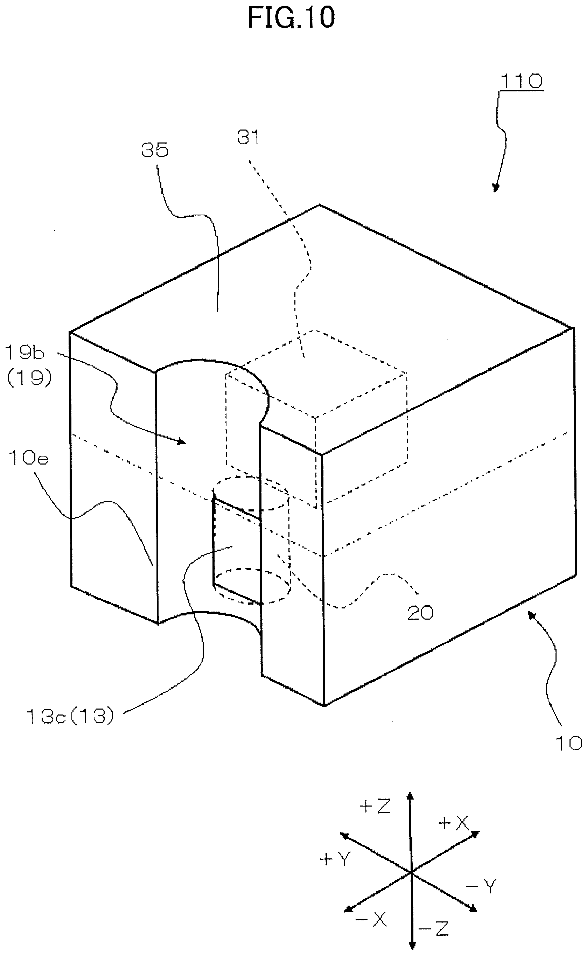

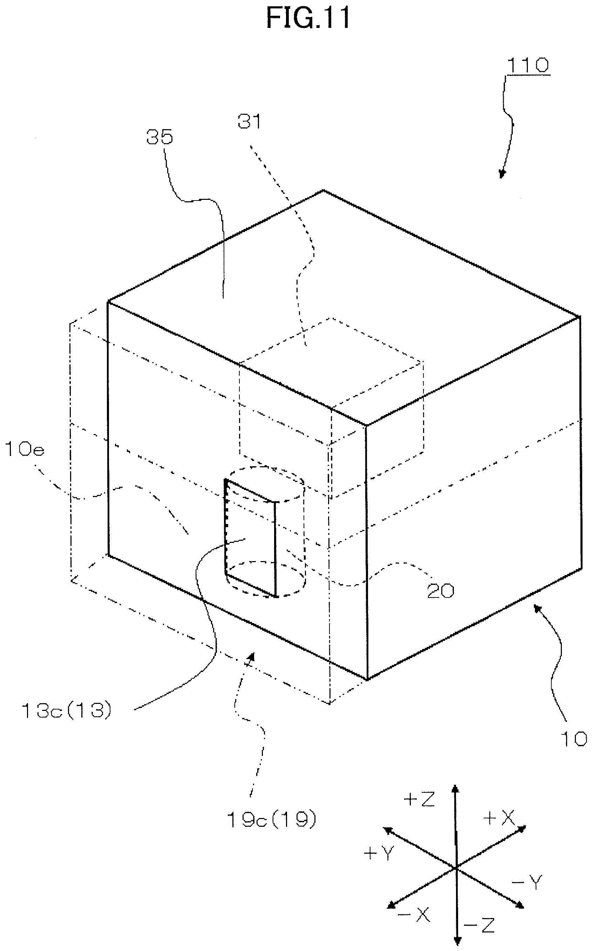

Next, referring to Fig. 10 and Fig. 11, a state of an electric circuit module 110 in the second test method (second modified example, third modified example) of an electric circuit module 110 according to an embodiment of the present invention, that is, a state of the electric circuit module 110 at the time of preliminary work for performing error analysis, will be described. Fig. 10 is a partially enlarged schematic drawing of the electric circuit module 110 in the second test method (second modified example). Fig. 11 is a partially enlarged schematic drawing of the electric circuit module 110 in the second test method (third modified example).

The structure of the electric circuit module of the second test method (second modified example and third modified example) is the same as the structure of the electric circuit module 110 of the second test method (first modified example). Therefore, the descriptions of the structure of the electric circuit module 110 will be omitted.

As illustrated in Fig. 10, the second test method (second modified example) of the electric circuit module is a test method in which the ground part 19 is formed throughout the multi-layer substrate 10 and the sealing resin 35 of the electric circuit module 110. The above-described ground part 19 in the second test method (second modified example) is a partial ground part 19b.

The partial ground part 19b is formed, for example, in a semicircle shape in a plan view by grinding the side end portion 10e of the multi-layer substrate 10 on the side on which the electric part 31 exists and by drilling a surface on the left side (a surface on -X side) of the sealing resin 35. By forming the partial ground part 19b, it is possible to expose the non-penetrating via hole 20 for testing the electric part 31 (i.e., the second test-use electrode 13c).
It should be noted that the partial ground part 19b is not limited to be a semicircle shape in a plan view, and may be a rectangular shape in a plan view. The partial ground part 19b may be formed by using a file having a semicircle shape or a rectangular shape.

In the second test method (second modified example) of the electric circuit module, even in the case where the size of the electric circuit module 110 is small, because of the fact that the partial ground part 19b is formed throughout (from the top to the bottom of) the outline of the left side (-X side) of the electric circuit module 110, compared with the second test method (first modified example) of the electric circuit module, it is easier to form the ground part 19 regardless of the position of the second test-use electrode 13c in the up-and-down direction.

As illustrated in Fig. 11, the second test method (third modified example) of the electric circuit module is a test method in which the ground part 19 is formed throughout the left side surface of the multi-layer substrate 10 and the sealing resin 35 of the electric circuit module 110. The above-described ground part 19 in the second test method (third modified example) is a total ground part 19c.

The total ground part 19c is formed by grinding the entire surface on the left side (surface in -X side) of the side end portion 10e of the multi-layer substrate 10 and the sealing resin 35, and by having the left side surface of the multi-layer substrate 10 and the sealing resin 35 ground. By forming the total ground part 19b, it is possible to expose the non-penetrating via hole 20 for testing the electric part 31 (i.e., the second test-use electrode 13c). The total ground part 19c may be formed by using a file having a planar shape, or the like.

In the second test method (third modified example) of the electric circuit module, even in the case where the size of the electric circuit module 110 is very small, because of the fact that the total ground part 19c is formed throughout the outline surface of the electric circuit module 110 on -X side, compared with the second test method (first modified example and second modified example) of the electric circuit module, it is further easier to form the ground part 19 regardless of the position of the second test-use electrode 13c in the Z direction and in the Y direction.

In the following, effects according to an embodiment of the present invention will be described.

The above-described electric circuit module includes the test-use electrodes used for an error analysis at a position, in an inner layer of the multi-layer substrate, at which the test-use electrodes overlap the land electrodes in a plan view. Therefore, it is not necessary for the electric circuit module to have an area that is used for exposing the test-use electrodes in the bottom layer of the multi-layer substrate. As a result, it is not necessary to increase an area of the bottom layer 10b of the multi-layer substrate 10, and thus, it becomes possible to reduce the size of the electric circuit module 100.

Further, because of the fact that the test-use electrodes 13 are formed by non-penetrating via holes 20, the test-use electrodes 13 have a thickness in the thickness direction of the multi-layer substrate 10, and have a thickness in the lateral direction of the multi-layer substrate 10. As a result, even when the accuracy of the grinding amount of the insulating layer 10d of the multi-layer substrate 10 is low, the test-use electrodes 13 can be still exposed easily.

Further, because of the fact that the lower end surface 14 of the first test-use electrode 13a is provided at one layer above the bottom layer 10b of the multi-layer substrate 10, when exposing the test-use electrode 13 used for an error analysis, it is only necessary to grind the insulating layer 10d of the bottom layer 10b of the multi-layer substrate 10. Further, because of the fact that no wiring pattern is provided in the bottom layer 10b of the multi-layer substrate 10, no wiring pattern 17 will be cut.

Further, because of the fact that the second test-use electrode 13b is provided in the vicinity of the side end portion 10e of the multi-layer substrate 10, when exposing the test-use electrode 13 used for an error analysis, it is only necessary to grind the side end portion 10e of the multi-layer substrate 10. Further, because of the fact that no wiring pattern 17 is provided at least at a position, of the side end portion 10e of the multi-layer substrate 10, in the vicinity of the second test-use electrode 13b, no wiring pattern 17 will be cut.

Further, as it is possible to cause the length of the non-penetrating via holes 20, which form the test-use electrodes 13, to be a minimum required length, the impact on the performance of the electric circuit module 100 can be reduced.

Further, it is possible to improve the wiring space efficiency by using a pad-on-via 23 in which the connection lands 20a of the non-penetrating via holes 20 are used in common with the part pads 15 in the top layer 10a.

Further, even though the electric parts 31 are sealed with sealing resin 35, it is not necessary to grind the sealing resin 35 in order to expose the test-use electrode 13.

Further, in the first test method of the electric circuit module, because of the fact that the lower end surface 14 of the first test-use electrode 13a is provided at one layer above the bottom layer 10b of the multi-layer substrate 10, it is only necessary to grind the insulating layer 10d of the bottom layer 10b of the multi-layer substrate 10 when exposing the test-use electrode 13 used for an error analysis. Further, because of the fact that no wiring pattern 17 is provided in the bottom layer 10b of the multi-layer substrate 10, no wiring pattern 17 will be cut. Therefore, preliminary work for performing error analysis becomes easier.

Further, in the second test method of the electric circuit module, because of the fact that the second test-use electrode 13b is provided in the vicinity of the side end portion 10e of the multi-layer substrate 10, it is only necessary to grind the side end portion 10e of the multi-layer substrate 10 when exposing the test-use electrode 13 used for an error analysis. Further, because of the fact that no wiring pattern 17 is provided at least at a position, of the side end portion 10e of the multi-layer substrate 10, in the vicinity of the second test-use electrode 13b, no wiring pattern 17 will be cut. Therefore, preliminary work for performing error analysis becomes easier.

As described above, in an electric circuit module according to an embodiment of the present invention, because of the fact that the test-use electrodes used for an error analysis are provided at a position, in an inner layer of the multi-layer substrate, at which the test-use electrodes overlap the land electrodes in a plan view, it is not necessary to have an area that is used for exposing the test-use electrodes in the bottom layer of the multi-layer substrate. As a result, it is not necessary to increase an area of the bottom layer of the multi-layer substrate, and thus, it becomes possible to reduce the size of the electric circuit module. Further, in the first test method of the electric circuit module, because of the fact that the lower end surface of the first test-use electrode is provided at one layer above the bottom layer of the multi-layer substrate, it is only necessary to grind the insulating layer of the bottom layer of the multi-layer substrate when exposing the test-use electrode used for an error analysis. Further, because of the fact that no wiring pattern is provided in the bottom layer of the multi-layer substrate, no wiring pattern will be cut. Therefore, preliminary work for performing error analysis becomes easier. Further, in the second test method of the electric circuit module, because of the fact that the second test-use electrode is provided in the vicinity of the side end portion of the multi-layer substrate, it is only necessary to grind the side end portion of the multi-layer substrate when exposing the test-use electrode used for an error analysis. Further, because of the fact that no wiring pattern is provided at least at a position, of the side end portion of the multi-layer substrate, in the vicinity of the second test-use electrode, no wiring pattern will be cut. Therefore, preliminary work for performing error analysis becomes easier.

An embodiment of the present invention is not limited to the above-described embodiments. Various modifications may be possible without departing from the subject matter of the present invention.

### [DESCRIPTION OF THE REFERENCE NUMERALS]

- 10: multi-layer substrate
- 10a: top layer
- 10b: bottom layer
- 10c: inner layer
- 10d: insulating layer
- 10e: side end portion
- 11: land electrode
- 11a: first land electrode
- 11b: second land electrode
- 13: test-use electrode
- 13a: first test-use electrode
- 13b: second test-use electrode
- 14: lower end surface
- 15: part pad
- 17: wiring pattern
- 19: ground part
- 19a: grilled hole
- 19b: partial ground part
- 19c: total ground part
- 20: non-penetrating via hole
- 20a: connection land
- 21: stacked via hole
- 23: pad on via
- 30: electric circuit
- 31: electric part
- 35: sealing resin
- 100: electric circuit module
- 110: electric circuit module

## Claims

1. An electric circuit module comprising:
a multi-layer substrate; and
a plurality of electric parts mounted on a top layer of the multi-layer substrate, wherein
a plurality of land electrodes that are necessary for normal operations are provided in a bottom layer of the multi-layer substrate,
test-use electrodes connected to the electric parts are provided in an inner layer of the multi-layer substrate,
the test-use electrodes are not connected to the land electrodes, and
the test-use electrodes are provided at a position at which the test-use electrodes overlap the land electrodes in a plan view.

2. The electric circuit module according to claim 1, wherein the test-use electrodes are formed by non-penetrating via holes made of conductive material.

3. The electric circuit module according to claim 2, wherein at least one of the test-use electrodes is a first test-use electrode whose lower end surface is provided at one layer above the bottom layer of the multi-layer substrate, and no wiring pattern is provided in the bottom layer of the multi-layer substrate.

4. The electric circuit module according to claim 2, wherein at least one of the test-use electrodes is a second test-use electrode that is provided in the vicinity of the side end portion of the multi-layer substrate, and no wiring pattern is provided at least at a position, of the side end portion of the multi-layer substrate, in the vicinity of the second test-use electrode.

5. The electric circuit module according to any one of claims 2 to 4, wherein the non-penetrating via holes are stacked via holes that are formed in a straight line in a direction perpendicular to the top layer of the multi-layer substrate.

6. The electric circuit module according to any one of claims 2 to 5, wherein part pads for the electric parts are provided in the top layer of the multi-layer substrate, and connection lands of the non-penetrating via holes in the top layer are used in common with the part pads.

7. The electric circuit module according to any one of claims 1 to 6, wherein the electric parts are sealed with resin.

8. A test method of an electric circuit module that includes a multi-layer substrate and a plurality of electric parts that are mounted on a top layer of the multi-layer substrate, a plurality of land electrodes necessary for normal operations being provided in a bottom layer of the multi-layer substrate, and test-use electrodes that are connected to the electric parts being provided in an inner layer of the multi-layer substrate, the test method comprising:
providing the test-use electrodes at a position at which the test-use electrodes overlap the land electrodes in a plan view;
causing at least one of the test-use electrodes to be a first test-use electrode whose lower end surface is provided at one layer above the bottom layer of the multi-layer substrate;
not connecting the first test-use electrode to the land electrodes;
not providing a wiring pattern in the bottom layer of the multi-layer substrate; and
exposing the first test-use electrode by grinding the bottom layer of the multi-layer substrate at the time of analysis.

9. A test method of an electric circuit module that includes a multi-layer substrate and a plurality of electric parts that are mounted on a top layer of the multi-layer substrate, a plurality of land electrodes necessary for normal operations being provided in a bottom layer of the multi-layer substrate, and test-use electrodes that are connected to the electric parts being provided in an inner layer of the multi-layer substrate, the test method comprising:
providing the test-use electrodes at a position at which the test-use electrodes overlap the land electrodes in a plan view;
causing at least one of the test-use electrodes to be a second test-use electrode that is provided in the vicinity of a side end portion of the multi-layer substrate;
not connecting the second test-use electrode to the land electrodes;
not providing a wiring pattern at least at a position, of the side end portion of the multi-layer substrate, in the vicinity of the second test-use electrode; and
exposing the second test-use electrode by grinding the side end portion of the multi-layer substrate at the time of analysis.
